# EUROPÄISCHE PATENTSCHRIFT

(11) **EP 1 333 346 B1**
(45) Veröffentlichungstag und Bekanntmachung des Hinweises auf die Patenterteilung: **28.07.2010**
(21) Anmeldenummer: 03001638.0
(22) Anmeldetag: 24.01.2003
(51) Int. Cl.: G05B 9/02, H02H 7/08

(54) **Verfahren und Einrichtung zur Fehlerdiagnose an gesteuerten elektrischen Antrieben**
Method and device for fault diagnosis in controlled electrical drives
Procédé et dispositif de diagnostic de défauts dans des entraînements à commande électronique

(30) Priorität: 01.02.2002 DE 10204039
(43) Veröffentlichungstag der Anmeldung: 06.08.2003
(73) Patentinhaber: Continental Automotive GmbH, 30165 Hannover (DE)
(72) Erfinder: Hadamik, Matthias, 61348 Bad Homburg (DE)

(56) Entgegenhaltungen:
- DE-A- 19 858 697
- PATENT ABSTRACTS OF JAPAN Bd. 013, Nr. 198 (E-756), 11. Mai 1989 (1989-05-11) & JP 01 019914 A (MITSUBISHI HEAVY IND LTD; others: 01), 24. Januar 1989 (1989-01-24)

## Beschreibung

Die Erfindung betrifft ein Verfahren und eine Einrichtung zur Fehlerdiagnose an gesteuerten elektrischen Antrieben, wobei ein Elektromotor über mindestens eine Leitung an eine Leistungsendstufe angeschlossen ist und ein Steuergerät die Endstufe mit Impulsen ansteuert und wobei im Falle eines unzulässig hohen Stroms eine Notabschaltung erfolgt.

An durch Halbleiterschalter gesteuerten elektrischen Antrieben werden meist Maßnahmen ergriffen, um die Leistungsendstufe und gegebenenfalls den Elektromotor vor Überlastung zu schützen. Üblicherweise wird dabei der Strom durch den Elektromotor gemessen und bei Erreichen eines unzulässig hohen Stroms eine Notabschaltung ausgelöst.

Bei einem durch DE 198 58 697 A1 bekanntgewordenen Verfahren zur Überwachung des Betriebszustandes einer Last wird für den Fall vorgesorgt, dass bei einem nicht äußerst niederohmigen Kurzschluss (beispielsweise R > 30 mOhm ) oder bei einem blockierten Motor ein Stromfluss, der zum Ansprechen der Kurzschlusssicherung führt, nicht erreicht wird. Dann spricht eine Strombegrenzung an, die zur Folge hat, dass ein hoher gepulster Strom durch die Endstufe und den Motor fließt, der zu Schäden führen kann. Mit dem bekannten Verfahren ist eine Erkennung des Betriebszustandes der Last sowie eine situationsgerechte Ansteuerung der Last in Abhängigkeit von dem Betriebszustand möglich. Dazu wird das zur Begrenzung des Stromflusses durch die Last in seiner Pulsdauer variierte Ausgangssignal zur Bestimmung des Betriebszustandes der Last ausgewertet. Dabei stellt es sich jedoch als schwierig heraus, zwischen einem blockierten Motor und einem sogenannten weichen Kurzschluss zu unterscheiden. Auch reine Widerstandsmessungen sind wegen der ohnehin äußerst geringen Leitungsund Wicklungswiderstände in der Praxis nicht durchführbar.

Aufgabe der vorliegenden Erfindung ist es, zwischen einer Blockierung des Motors und einem sogenannten weichen Kurzschluss zuverlässig zu unterscheiden, nachdem wegen eines unzulässig hohen Stroms eine Notabschaltung ausgelöst wurde.

Diese Aufgabe wird bei dem erfindungsgemäßen Verfahren dadurch gelöst, dass nach einer Notabschaltung eine Wiedereinschaltung für eine vorgegebene Dauer erfolgt, dass bei einer wiederholten Abschaltung durch unzulässig hohen Strom während der vorgegebenen Dauer ein Leitungskurzschluss erkannt wird und dass nach Ablauf der vorgegebenen Dauer ohne Notabschaltung ein Blockieren des Elektromotors erkannt wird.

Dabei ist die vorgegebene Dauer länger als eine durch die Induktivität und den Widerstand der mindestens einen Leitung vorgegebene Zeitkonstante und kürzer als die durch die Induktivität und den Widerstand des Elektromotors bedingte Zeitkonstante ist. Das Ergebnis der Diagnose kann angezeigt oder in geeigneter Weise für eine spätere Reparatur gespeichert werden.

Eine erfindungsgemäße Einrichtung ist gekennzeichnet durch Mittel zur Wiedereinschaltung nach einer Notabschaltung für eine vorgegebene Dauer, Mittel zum Erkennen eines Leitungskurzschlusses bei einer wiederholten Abschaltung durch unzulässig hohen Strom während der vorgegebenen Dauer und Mittel zum Erkennen eines Blockierens des Elektromotors nach Ablauf der vorgegebenen Dauer ohne Notabschaltung.

Dabei ist vorgesehen, dass die vorgegebene Dauer länger als eine durch die Induktivität und den Widerstand der mindestens einen Leitung vorgegebene Zeitkonstante und kürzer als die durch die Induktivität und den Widerstand des Elektromotors bedingte Zeitkonstante ist.

Eine vorteilhafte Ausgestaltung der erfindungsgemäßen Einrichtung besteht darin, dass das Steuergerät eine programmierbare Einrichtung umfasst und dass zusätzlich eine mit einer Strommesseinrichtung verbundene Abschalteinrichtung zur Unterbrechung der Zuleitung der Impulse vom Steuergerät zur Leistungsendstufe und zur Meldung der Unterbrechung an die programmierbare Einrichtung vorgesehen ist. Dabei kann die Abschalteinrichtung aus einer bistabilen Schaltung bestehen, die von dem Impuls rückgesetzt und bei Überschreiten eines vorgegebenen Strompegels gesetzt wird.

Die Erfindung läßt zahlreiche Ausführungsformen zu. Eine davon ist schematisch in der Zeichnung anhand mehrerer Figuren dargestellt und nachfolgend beschrieben. Es zeigt:
Fig. 1 ein Ausführungsbeispiel einer erfindungsgemäßen Einrichtung als Blockschaltbild und
Fig. 2 bei der Einrichtung nach Fig. 1 auftretende Signale, soweit sie zum Verständnis der Erfindung erforderlich sind.

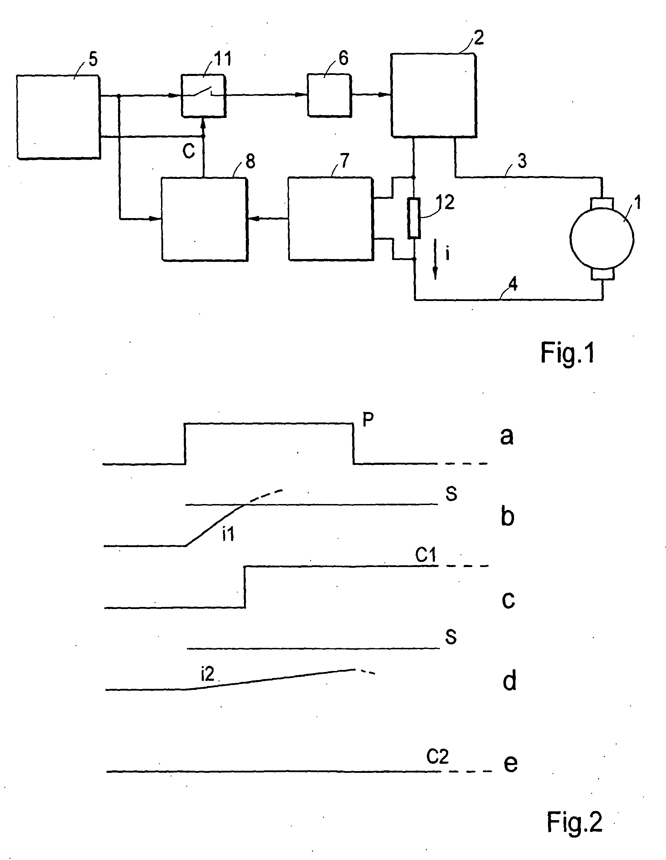

Bei der Einrichtung nach Fig. 1 ist ein Elektromotor 1 über zwei Leitungen 3, 4 mit einer Leistungsendstufe 2 verbunden, die vorzugsweise im Gegentakt betrieben wird, wozu in einem Steuergerät 5 pulsbreitenmodulierte Impulse über einen Treiber 6 der Endstufe 2 zugeführt werden.

In die Leitung 4 ist ein Strommesswiderstand 12 eingefügt, dessen Spannungsabfall einem Schwellwertschalter 7 zugeleitet wird, der bei Erreichen einer vorgegebenen Schwelle ein Signal zum Setzen einer bistabilen Schaltung 8 erzeugt. Diese bistabile Schaltung 8 wird von jeder positiven Flanke der von dem Steuergerät 5 erzeugten Steuerimpulse zurückgesetzt. Ein Ausgangssignal C der bistabilen Schaltung ist mit einem Steuereingang eines Schalters 11 und mit einem Eingang des Steuergerätes 5 verbunden.

Bei Erreichen eines höchstzulässigen Stromwertes bevor der jeweilige Steuerimpuls zu Ende ist, wird der Schalter 11 geöffnet, so dass der Steuerimpuls verkürzt wird und damit eine Strombegrenzung eintritt. Zusätzlich sind in dem Steuergerät 5 Mittel vorgesehen, welche die Endstufe 2 und damit den Elektromotor 1 im Falle einer Überlastung ganz abschalten. Bevor jedoch eine endgültige Abschaltung stattfindet, wird bei der erfindungsgemäßen Einrichtung ein kurzer in Fig. 2 a dargestellter Impuls P erzeugt und zur Endstufe 2 geleitet. Diese legt entsprechend kurzzeitig Spannung an die Reihenschaltung aus dem Motor 1 und den Leitungen 3 und 4.

Ist die Stromüberlastung durch einen Kurzschluss zwischen den Leitungen bedingt, steigt der Strom i1 etwa gemäß Fig. 2b relativ schnell an und erreicht noch vor dem Ende des Impulses P eine Schwelle S. Dies führt dazu, dass die Abschalteinrichtung 8 (Fig. 1) anspricht. Die Dauer des Impulses P ist derart ausgelegt, dass auch bei einem Leitungskurzschluss in der Nähe des Motors 1 - bei einem sogenannten weichen Kurzschluss - der Strom i den Schwellwert S vor dem Ende des Impulses P erreicht. Nach dem Impuls P wird dann von dem Steuergerät das Ausgangssignal C1 (Fig. 2c) abgefragt.

Ist jedoch die Überlastung durch ein Blockieren oder eine besondere Schwergängigkeit des Elektromotors 1 bedingt, wirkt im Ausgangskreis der Leistungsendstufe 2 zusätzlich die Induktivität des Elektromotors, die beispielsweise 50 µH gegenüber einer Induktivität einer mehrere Meter langen Leitung von beispielsweise 7 µH beträgt. Wie in Fig. 2d dargestellt ist, erreicht wegen dieser großen Induktivität der Strom i2 während der Dauer des Impulses P den Schwellwert S nicht, was in dem Steuergerät registriert wird, da der Pegel des Abschaltsignals C2, wie in Fig. 2e dargestellt, bei 0 bleibt. Somit kann angezeigt oder registriert werden, dass es sich bei der Überlastung um ein Blockieren des Motors handelt.

## Patentansprüche

1. Verfahren zur Fehlerdiagnose an gesteuerten elektrischen Antrieben,
wobei ein Elektromotor über mindestens eine Leitung an eine Leistungsendstufe angeschlossen ist und ein Steuergerät die Endstufe mit Impulsen ansteuert
und wobei im Falle eines unzulässig hohen Stroms eine Notabschaltung erfolgt,
**dadurch gekennzeichnet,**
**dass** nach einer Notabschaltung eine Wiedereinschaltung für eine vorgegebene Dauer erfolgt, die länger als eine durch die Induktivität und den Widerstand der mindestens einen Leitung vorgegebene Zeitkonstante und kürzer als die durch die Induktivität und den Widerstand des Elektromotors bedingte Zeitkonstante ist,
**dass** bei einer wiederholten Abschaltung durch unzulässig hohen Strom während der vorgegebenen Dauer ein Leitungskurzschluss erkannt wird
und **dass** nach Ablauf der vorgegebenen Dauer ohne Notabschaltung ein Blockieren des Elektromotors erkannt wird.

2. Einrichtung zur Fehlerdiagnose an gesteuerten elektrischen Antrieben,
wobei ein Elektromotor (1) über mindestens eine Leitung (3, 4) an eine Leistungsendstufe (2) angeschlossen ist und ein Steuergerät (5) die Endstufe mit Impulsen ansteuert und wobei im Falle eines unzulässig hohen Stroms eine Notabschaltung erfolgt,
**gekennzeichnet durch**
Mittel zur Wiedereinschaltung nach einer Notabschaltung für eine vorgegebene Dauer, die länger als eine **durch** die Induktivität und den Widerstand der mindestens einen Leitung (3, 4) vorgegebene Zeitkonstante und kürzer als die **durch** die Induktivität und den Widerstand des Elektromotors (1) bedingte Zeitkonstante ist,
Mittel zum Erkennen eines Leitungskurzschlusses bei einer wiederholten Abschaltung **durch** unzulässig hohen Strom während der vorgegebenen Dauer und
Mittel zum Erkennen eines Blockierens des Elektromotors (1) nach Ablauf der vorgegebenen Dauer ohne Notabschaltung.

3. Einrichtung nach Anspruch 2, **dadurch gekennzeichnet, dass** das Steuergerät (5) eine programmierbare Einrichtung umfasst und dass zusätzlich eine mit einer Strommesseinrichtung (12) verbundene Abschalteinrichtung (7, 8) zur Unterbrechung der Zuleitung der Impulse vom Steuergerät (5) zur Leistungsendstufe (2) und zur Meldung der Unterbrechung an die programmierbare Einrichtung (5) vorgesehen ist.

4. Einrichtung nach Anspruch 3, **dadurch gekennzeichnet, dass** die Abschalteinrichtung aus einer bistabilen Schaltung (8) besteht, die von dem Impuls rückgesetzt und bei Überschreiten eines vorgegebenen Strompegels gesetzt wird.

## Claims

1. Method for error diagnosis in controlled electric drives, whereby an electric motor is connected via at least one line to a power end stage and a controller transmits pulses to the end stage,
and whereby an emergency switch-off occurs in the event of impermissibly high current,
**characterised in that**
following an emergency switch-off a restart occurs for a given duration which is longer than a time constant preset by the inductivity and the resistance of the at least one line and shorter than the time constant conditioned by the inductivity and the resistance of the electric motor,
that a line short circuit is identified in the event of a repeated switch-off as a result of impermissibly high current during the given duration
and that after expiry of the given duration without emergency switch-off a blocking of the electric motor is identified.

2. Apparatus for error diagnosis in controlled electric drives,
whereby an electric motor (1) is connected via at least one line (3, 4) to a power end stage (2) and a controller (5) transmits pulses to the end stage,
and whereby an emergency switch-off occurs in the event of impermissibly high current,
**characterised by**
means for restart following an emergency switch-off for a given duration which is longer than a time constant preset by the inductivity and the resistance of the at least one line (3, 4) and shorter than the time constant conditioned by the inductivity and the resistance of the electric motor (1), means for identifying a line short circuit in the event of a repeated switch-off as a result of impermissibly high current during the given duration
and means for identifying a blocking of the electric motor (1) after expiry of the given duration without emergency switch-off.

3. Apparatus according to claim 2, **characterised in that** the controller (5) comprises a programmable apparatus and that in addition a switch-off apparatus (7, 8) connected to a current measurement apparatus (12) is provided for interrupting the supply of pulses from the controller (5) to the power end stage (2) and for reporting the interruption to the programmable apparatus (5).

4. Apparatus according to claim 3, **characterised in that** the switch-off device consists of a bistable circuit (8) which is reset by the pulse and is set when a given current level is exceeded.

## Revendications

1. Procédé de diagnostic d'erreurs sur des entraînements électriques commandés,
dans lequel un moteur électrique est connecté par au moins une ligne à un étage de sortie de puissance et un appareil de commande commande l'étage de sortie avec des impulsions
et dans lequel, dans le cas d'un courant inacceptablement élevé, il se produit un arrêt d'urgence, **caractérisé en ce que**,
après un arrêt d'urgence, une remise en marche s'effectue pour une durée prédéfinie, qui est supérieure à une constante de temps prédéfinie par l'inductance et la résistance de la au moins une ligne, et inférieure à la constante de temps conditionnée par l'inductance et la résistance du moteur électrique,
un court-circuit de ligne est identifié lors d'un arrêt répété dû à un courant inacceptablement élevé pendant la durée prédéfinie
et, à l'issue de la durée prédéfinie sans arrêt d'urgence, un blocage du moteur électrique est identifié.

2. Dispositif de diagnostic d'erreurs sur des entraînements électriques commandés,
dans lequel un moteur électrique (1) est connecté par au moins une ligne (3, 4) à un étage de sortie de puissance (2) et un appareil de commande (5) commande l'étage de sortie avec des impulsions et dans lequel, dans le cas d'un courant inacceptablement élevé, il se produit un arrêt d'urgence,
**caractérisé par**
des moyens de remise en marche après un arrêt d'urgence pour une durée prédéfinie, qui est supérieure à une constante de temps prédéfinie par l'inductance et la résistance de la au moins une ligne (3, 4) et inférieure à la constante de temps conditionnée par l'inductance et la résistance du moteur électrique (1),
des moyens d'identification d'un court-circuit de puissance dans le cas d'un arrêt répété dû à un courant inacceptablement élevé pendant la durée prédéfinie, et
des moyens d'identification d'un blocage du moteur électrique (1) à l'issue de la durée prédéfinie sans arrêt d'urgence.

3. Dispositif selon la revendication 2, **caractérisé en ce que** l'appareil de commande (5) comprend un dispositif programmable et **en ce qu'**il est prévu en outre un dispositif d'arrêt (7, 8) connecté à un dispositif de mesure de courant (12) et susceptible d'interrompre l'acheminement des impulsions de l'appareil de commande (5) à l'étage de sortie de puissance (2) et de notifier l'interruption au dispositif programmable (5).

4. Dispositif selon la revendication 3, **caractérisé en ce que** le dispositif d'arrêt est constitué d'un circuit bistable (8), qui est réinitialisé par l'impulsion et initialisé lorsqu'un niveau de courant prédéfini est dépassé.
